# EUROPÄISCHE PATENTSCHRIFT

(11) **EP 0 576 707 B1**
(45) Veröffentlichungstag und Bekanntmachung des Hinweises auf die Patenterteilung: **08.05.1996**
(21) Anmeldenummer: 92111118.3
(22) Anmeldetag: 01.07.1992
(51) Int. Cl.: H01L 41/08

(54) **Translatorstapel und Verfahren zu dessen Herstellung**
Stack for translational movement and method of making the same
Empilement pour mouvement de translation et procédé de sa production

(43) Veröffentlichungstag der Anmeldung: 05.01.1994
(73) Patentinhaber: TRIDELTA GmbH, D-07629 Hermsdorf (DE)
(72) Erfinder: Voigt, Konrad, O-6532 Bad Klosterlausitz (DE); Meier, Wilfried, O-6530 Hermsdorf (DE); Geiss, Wolfgang, O-6540 Stadtroda (DE)

(56) Entgegenhaltungen:
- DE-A- 3 330 538
- US-A- 4 978 881
- PATENT ABSTRACTS OF JAPAN vol. 11, no. 110 (E-496) 7. April 1987 & JP-A-61 258 485

## Beschreibung

Die Erfindung betrifft einen Translatorstapel, der aus einer Vielzahl von piezokeramischen Scheibe, die mit Oberflächenmetallisierungen als Elektroden versehen sind, besteht. Wobei gleichpolig anzusteuernde Elektroden an jeweils einer Seite des Stapels heransgeführt sind. Gleichzeitig beinhaltet die Erfindung ein Verfahren zum Herstellen eines Translatorstapels.

Es sind einige Möglichkeiten der Elektrodengestaltung für die einzelnen Scheiben bekannt. Ganzflächige Metallisierungen der gegenüberliegenden Hauptflächen führt notwendigeriweise entweder zu aufwendigen Maßnahmen bei der äußeren Parallelschaltung gleichsinnig angesteuerter Elektroden (DE 321 8576) oder zu aufwendigen Isolationsmaßnahmen auf der ßauelementekante, z.B. bei monolithischen Vielschichtaktuatoren.

Um diese Nachteile zu vermeiden, wird in der DE-OS 333 0538 eine Metallisierung der Einzelscheiben derart; vorgeschlagen, daß eine Flächenelektrode jeweils auf die gegenüberliegende Seitenkante herumreicht. Dies bedingt einen elektrodenfreien Streifen auf jeder Hauptfläche der Scheibe, der jeweils die Isolation der Elektroden zueinander gewährleistet.

Eine ähnliche technische losüng ist in JP-A-61-258 485 offenbart

In diesen elektrodenfreien Streifen treten beim elektrischen Ansteuern der Scheiben Feldeformationen auf, die zu einer geringeren Dehnung bzw. sogar zu Kontraktionen in Richtung der Wirkachse des Stapels führen. Die Folge davon sind hohe innere mechanische Spannungen zwischen regular kontaktierten Gebieten, in denen das elektrische Feld parrallel zur Wirkachse des Stapels verläuft, und den Gebieten der Isolierstreifen, in denen die Feldrichtung von der Wirkachse abweicht.

Diese mechanische Spannungen führen bei ßetrieb des Translatorstapels, wie schon angedeutet, zu Energieund Dehnungsverlusten, zu Inhomogenitäten der Dehnung über den Wirkquerschnitt, zu Verlusten an Steifigkeit und im Extremfall, z,B. bei hochdynamischem Betrieb, zur Zerstörung des Verbundes.

Die Aufgabe der Erfindung besteht daher darin, einen Stapelaufbau anzugeben, der einerseits den Aufwand für eine äußere Verschaltung bzw. Elektkrodenisolation, der bei ganzflächiger Metallisierung der Hauptflächen der Einzelscheiben entsteht, vermindert und andererseits die beschriebenen Nachteile, die mit der Anordnung der Isolationsstreifen auf den Hauptflächen der Scheiben auftreten, vermeidet. Die Erfindung soll insbesondere Für kleine Scheibendicken (<0,3 mm) eine kostengünstige Fertigung erlauben.

Aufgabe der Erfindung ist es weiterhin, ein Verfahren zur Herstellung eines Translatorstapels anzugeben, das gewährleistet, daß Stapel auf effektiver Weise in den benötigten Abmessungen und Eigenschaften bereitgestellt werden können.

Diese Aufgabe wird, wie in den Ansprüchen 1 bis 6 beschrieben, gelöst.

Weitere Erläuterungen der Erfindungen gehen aus den nachfolgenden auf der Basis der Zeichnungen beschriebenen Ausführungsbeispielen hervor.

Es zeigen:
- Fig. 1:: eine Einzelscheibe mit einer erfindungsgemäßen Metallisierung
- Fig. 2:: eine Einzelscheibe mit einer weiteren erfindungsgemäßen Metallisierung

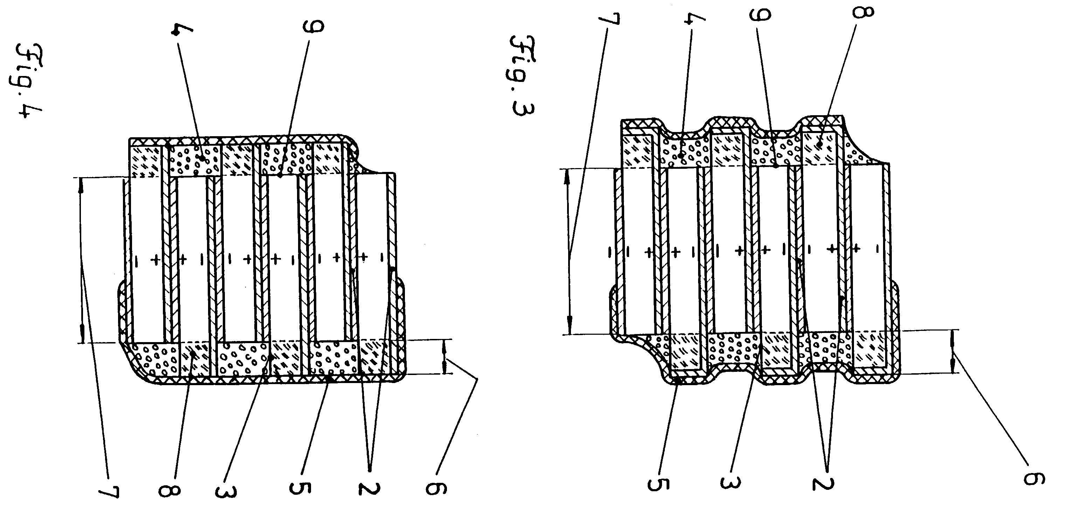

- Fig. 3:: eine Schnittdarstellung eines erfindungsgemäßen Stapels in Trennrichtung bei Verwendung von Scheiben nach Fig. 1
- Fig. 4:: eine Schnittdarstellung eines erfindungsgemäßen Stapels in Trennrichtung bei Verwendung von Scheiben nach Fig. 2
- Fig. 5:: eine Prinzipdarstellung zur Trennung des ursprünglichen Stapels gemäß Beispiel 1 und Fig. 3
- Fig. 6:: eine Prinzipdarstellung zur Trennung des ursprünglichen Stapels gemäß Beispiel 2 und Fig. 4.

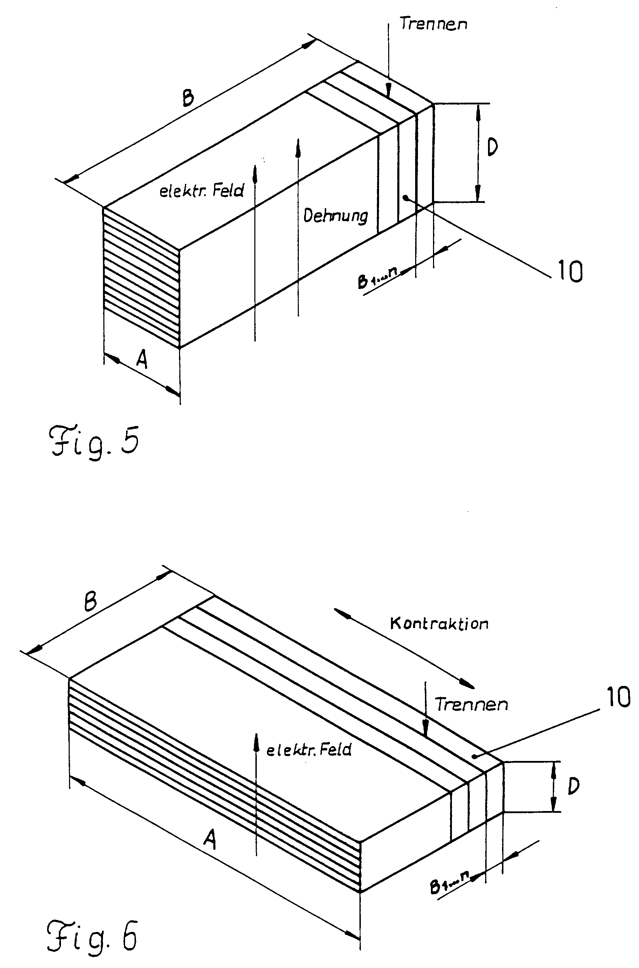

Die in den Fig. 5 und 6 angedeuteten Pfeile sollen die Richtung des elektrischen Feldes bei Betrieb des Stapels verdeutlichen, wobei auch die weiter unten beschriebenen Einzelstapel gemeint sind.

Die Stapelung der Scheiben 1 erfolgt so, daß das Gebiet mit irregulärer Feldverteilung 8 sich außerhalb des quasimonolithischen Wirkquerschnittes 7 befindet und dort nur die Funktion des Trägers der Metallisierungen 2; 5 hat.

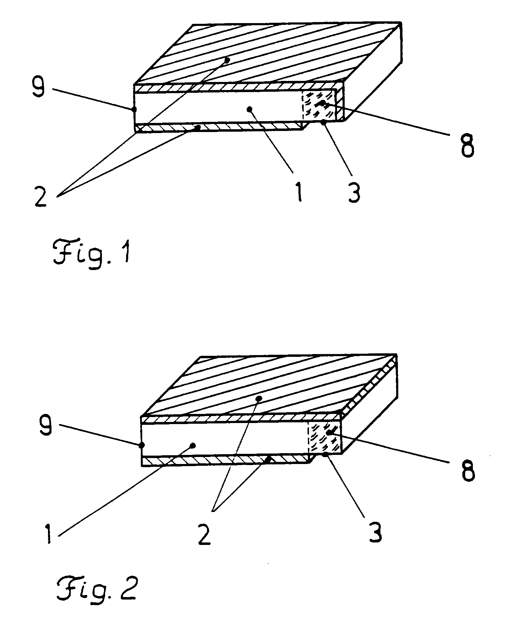

Die Fig. 1 und 2 zeigen dabei die zwei Möglichkeiten der Metallisierung (Elektroden), um den beabsichtigten Versatz 6 bei der Stapelung der Scheiben 1 realisieren zu können.

Die Herstellung des Stapelverbundes geschieht durch Verklebung und zwar derart, daß eine galvanische Kontaktgabe benachbarter Elektroden 2 erfolgt und nur eine dieser Elektroden nach außen geführt und jeweils mit den anderen herausgefürten Elektroden gleicher Polarität durch eine elektrisch leitende Beschichtung 5 miteinander verbunden wird. Die bevorzugte Verwendung des Klebers zur Füllung der beim versetzten Stapeln entstehenden spaltförmigen Vertiefungen wird anschließend in den beiden Beispielen beschrieben. Die mechanische Steifigkeit des ausgehärteten Klebers muß im Vergleich zu der der Keramik vernachlässigbar sein.

### Beispiel 1:

Es werden 50 Stück piezokeramische Einzelscheiben 1 mit den Abmessungen 55 × 5,5 × 0,3, wie in Fig. 1 dargestellt, mit Metallisierungen (Elektroden) 2 versehen und anschließend polarisiert. Danach erfolgt; die Stapelung der Scheiben unter Einsatz eines handelsüblichen Klebers 4 und bei Anwendung von Druck. Der Kleber 4 wird dabei so dosiert, daß die durch den Versatz 6 entstandennen Fugen zu etwa 50 % gefüllt werden. Nach dem Aushärten des Klebers bei 120°C erfolgt eine Reinigung der Seitenflächen des Stapels. Anschließend werden diese Seitenflächen mit einem Sputterverfahren metallisiert 5, so daß alle nach jeweils einer Seite herausgezogenen Elektroden 2 elektrisch leitend miteinander verbunden werden.

Der entstandene Stapel mit den Abmessungen 6 × 55 × 15 mm (A × B × D) (Fig. 5) wird mit einer Gattertrennsäge senkrecht zur Seitenmetallisierung 5 in 10 Einzelstapel 10 der Größe 5 × 6 × 15 mm zerlegt. Die einzelnen Stapel werden drahtkontaktiert und mit einem Schutzlack umhüllt.

Beim Anlegen einer Gleichspannung von 600 V führt der Einzelstapel eine Dehnung in Feldrichtung von ca. 20 µm aus.

Auf die beim Trennsägen entstehenden Flächen der Einzelstapel 10 können nach einem Waschvorgang ein oder mehrere Dehnmeßstreifen als Dehnungssensor zu Meß- und Regelzwecken aufgebracht werden.

### Beispiel 2:

Es werden 40 piezokeramische Folien der Abmessung 55 × 20 × 0,1 mm gemäß Fig. 2 durch ein Dickschichtverfahren mit Ag-Paste der Schichtdicke 5 µm so metallisiert, daß die Isolationsstreifen 3 (Isolation auf der Scheibenfläche) parallel zu den kurzen Seitenkanten verlaufen.

Die Folien 1 werden wie in Fig. 4 dargestellt, versetzt gestapelt, wobei sie mit einem Kleber als Bindemittel unter Druck verfügt werden. ner aus dem Spalt zwischen den einzelnen Folien austretende Kleber füllt die beim versetzten Stapeln entstandenen Fugen voilständig und bedeckt auch die hervorstehenden Folienkanten.

Noch den Aushärten des klebers bei 120°C werden die Seitenkanten des Stapels überschliffen, bis die Keramik und die herausgezogenen Elektroden 2 angeschliffen sind. Nach einem Waschvorgang werden die Steitenflächen durch ein Sputterverfahren mit einer Ag-Schicht 5 metallisiert, die die jeweils nach einer Seite herausgezogenen Elektroden gleicher Polarität elektrisch miteinander verbindet.

Der Stapel mit den Abmessungen 55,5 × 2O × 4 mm (A × B × D) (Fig. 6) wird anschließend in 6 Einzelstapel 10 der Abmessung 4 × 3 × 55,5 mm (D × B₁ × A) zerlegt. Es entsteht so eine Vielzahl von Einzelstapel 10 mit kleinem Wirkquerschnitt (D × B₁) und großer wirksamer Länge A.

Nach dem Abschluß von Kontaktdrähten und Endstücken an die kleinen Seiteflächen der nun entstandenen Einzelstapel 10 werden diese polarisiert. Der Translatorstapel führt beim Anlegen einer Gleichspannung von 200 V eine Kontraktion senkrecht zur Feldrichtung (Richtung A) von etwa 45 µm aus.

## Patentansprüche

1. Translatorstapel, bestehend aus einer Vielzahl von piezokeramischen Scheiben, die mit Oberflächenmetallisierungen als Elektroden versehen sind, wobei gleichpolig anzusteuernde Elektroden an jeweils einer Seite des Stapels herausgeführt sind, gekennzeichnet dadurch, daß bei jeder Scheibe (1) Isolationsbereiche einerseits zwischen den jeweils beiden Metallisierungen (2) auf einer Scheibenkante (9) und andererseits auf einer dieser Scheibenkante entgegengesetzten Seite einer Hauptfläche (3) vorhanden sind, wobei die einzelnen Scheiben (1) mit einem wechselseitigen Versatz (6) gestapelt sind, dessen Größe der Breite eines Bereiches (8) auf der Scheibe (1) entspricht, der außerhalb des quasimonolithischen Wirkungsquerschnitts (7) des Stapels liegt, wo durch die Elektrodenanordnung beim Betrieb des Stapels Felddeformationen entstehen.

2. Translatorstapel nach Anspruch 1, gekennzeichnet dadurch, daß die elektrische Isolation der metallisierten Scheiben (1) zueinander im Verbund durch eine vollständige oder teilweise Füllung der durch den Versatz der Scheiben entstandenen Vertiefungen mit elektrisch isolierendem Material (4), dessen mechanische Steifigkeit im Vergleich zu derjenigen der Keramik vernachlässigbar ist, gewährleistet wird.

3. Translatorstapel nach den Ansprüchen 1 und 2, gekennzeichnet dadurch, daß die gleichpolig anzusteuernden, an jeweils einer Seite des Stapels herausgeführten Elektroden (2) freigelegt und durch eine elektrisch leitende Seitenmetallisierung (5) parallel geschaltet sind.

4. Verfahren zur Herstellung eines Translatorstapels nach Anspruch 3, gekennzeichnet dadurch, daß der so gestapelte Stapel durch ein Trennverfahren in Einzelstapel (10) zerlegt wird, wobei die Schnittebene senkrecht zur Wirkfläche des ursprünglichen Stapels verläuft und beide Seitenmetallisierungen schneidet.

5. Verfahren zur Herstellung eines Translatorstapels nach Anspruch 4, gekennzeichnet dadurch, daß aus einem Stapel mit einer geringen Anzahl an großflächigen Einzelscheiben (1) durch Trennen ein Vielzahl von Einzelstapeln (10) mit kleinem Wirkquerschnitt D x B₁ und großer Länge A gebildet werden, deren Kontraktion in Richtung der großen Länge A bei angelegtem elektrischen Feld verwendet wird, wobei D die Dicke, B₁ die Breite und A die Länge des Einzelstapels sind.

6. Verfahren zur Herstellung eines Translatorstapels nach Anspruch 4 oder 5, gekennzeichnet dadurch, daß auf den jeweiligen Trennflächen der Einzelstapel ein oder mehrere Dehnmeßstreifen angebracht werden.

## Claims

1. Stack for translational movement, consisting of a plurality of piezoceramic disks which are provided with surface metal coatings to form electrodes, while electrodes allowing homopolar activation lead out of one of the sides of each stack, characterized by the fact that every disk (1) ) has insulation areas located between both metal coatings (2) at one disk edge (9) on the one hand, and on the side of a main surface (3) situated opposite with regard to this disk edge, while the individual disks (1) are stacked in such a way that they present an offset (6) on altemating sides, the size of this offset (6) corresponding to the width of an area (8) on disk (1), which area is situated outside of the stack's quasi-monolithic effective cross-section (7) in which field deformations are caused by the electrode arrangement during the operation of the stack.

2. Stack for translational movement as claimed in claim 1, characterized by the fact that the electrical insulation of the metal-coated disks (1) is guaranteed with regard to one another and within the bonded compound system by the complete or partial filling ofthe recesses created by the offsets between the disks, using electrically insulating material (4) which has a mechanical stiffness that is negligible in comparison with the stiffness ofthe ceramics.

3. Stack for translational movement as claimed in claims 1 and 2, characterized by the fact that the electrodes (2), leading out of one side of each stack and allowing homopolar activation are exposed and switched in parallel by an electrically conducting lateral metal coating (5).

4. Method of making a stack for translational movement as claimed in claim 3, characterized by the stack stacked in this way being separated into individual stacks (10) by means of separating process in which the sectional plane runs vertically with regard to the active area of the original stack and cuts both lateral metal coatings.

5. Method of making a stack for translational movement as claimed in claim 4, characterized by the fact that a plurality of individual stacks (10), presenting a small effective cross-section D x B₁ and a great length A is formed by cutting a stack which has a small number of individual disks (1) with a large surface, while the contraction ofthese individual stacks is used in the direction of the great length A when an electric field is applied, in which D is the thickness, B₁ is the width, and A is the length of the individual stack.

6. Method of making a stack for translational movement as claimed in claim 4 or 5, characterized by one or several wire strain gauges being arranged on the corresponding separating surfaces of the individual stacks.

## Revendications

1. Empilement pour mouvement de translation, consistant en une pluralité de disques piézocéramiques, pourvus d'un revêtement métallique superficiel formant les électrodes, les électrodes destinées à l'excitation homopolaire sortant d'un côté de chaque empilement, caractérisé en ce que chaque disque (1) présente des zones d'isolement situées, d'une part, entre chacun des deux revêtements métalliques (2) sur un bord des disque (9) et, d'autre part, sur un côté d'une surface principale (3) opposé à ce bord de disque, tandis que les disques individuels (1) sont empilés avec un décalage alternant (6) dont le dimensions correspondent à la largeur d'une zone (8), située sur le disque (1) et s'étendant à l'extérieur de la section efficace quasi-monolithique (7) de l'empilement dans laquelle des déformations de champ sont occasionnées par l'arrangement des électrodes au cours de l'opération de l'empilement.

2. Empilement pour mouvement de translation selon la revendication 1, caractérisé en ce que l'isolement électrique des disques (1) rêvetus de métal est assuré l'un par rapport à l'autre et à l'intérieur de la structure composite en utilisant un matériau (4) isolant d'une rigidité mécanique négligeable par rapport à celle du matériau céramique afin de remplir, de façon complète ou partielle, les creux créés par le décalage des disques.

3. Empilement pour mouvement de translation selon les revendications 1 et 2, caractérisé en ce que les électrodes destinées à l'excitation homopolaire et sortant d'un côté de chaque empilement sont exposées et branchées en parallèle au moyen d'un revêtement métallique latéral (5).

4. Procédé permettant la production d'un empilement pour mouvement de translation selon la revendication 3, caractérisé en ce que l'empilement créé de cette façon est séparé en empilements individuels (10) grâce à un procédé de séparation, la coupe passant verticalement par rapport à la surface active de l'empilement original et coupant les deux revêtements métalliques latéraux.

5. Procédé permettant la production d'un empilement pour mouvement de translation selon la revendication 4, caractérisé en ce qu'une pluralité d'empilements individuels (10), ayant une section efficace D x B₁ et une grande longueur A, est créée par séparation à partir d'un empilement comportant un nombre peu important de disques individuels (1) d'une grande surface, empilements individuels dont la contraction est utilisée dans la direction de la grande longueur A lorsqu'un champ électrique est appliqué, D étant l'épaisseur, B₁ la largeur et A la longueur de l'empilement individuel.

6. Procédé permettant la production d'un empilement pour mouvement de translation selon la revendication 4 ou 5, caractérisé en ce qu'une ou plusieures jauges de contraintes sont aménagées sur les surfaces de séparation correspondantes des empilements individuels.
